# FASCICULE DE BREVET EUROPEEN

(11) **EP 4 605 767 B1**
(45) Date de publication et mention de la délivrance du brevet: **28.10.2026**
(21) Numéro de dépôt: 23793001.1
(22) Date de dépôt: 15.09.2023
(51) Int. Cl.: G01R 31/367, G01R 31/382, G01R 31/3842, G01R 31/389, G01R 31/392

(54) **VEHICULE AUTOMOBILE COMPRENANT UN SYSTEME DE DETERMINATION D'IMPEDANCE DE BATTERIE DE TRACTION, PROCEDE ET PROGRAMME SUR LA BASE D'UN TEL VEHICULE**
KRAFTFAHRZEUG MIT EINEM SYSTEM ZUR BESTIMMUNG DER IMPEDANZ EINER TRAKTIONSBATTERIE, VERFAHREN UND PROGRAMM AUF BASIS SOLCH EINES FAHRZEUGS
MOTOR VEHICLE COMPRISING A SYSTEM FOR DETERMINING THE IMPEDANCE OF A TRACTION BATTERY, METHOD AND PROGRAM BASED ON SUCH A VEHICLE

(30) Priorité: 19.10.2022 FR 2210816
(43) Date de publication de la demande: 27.08.2025
(73) Titulaire: Stellantis Auto SAS, 78300 Poissy (FR)
(72) Inventeur: SHI, Zhihao, 78570 ANDRESY (FR); EDDAHECH, Akram, 78280 GUYANCOURT (FR); MAWONOU, Kodjo Senou Rodolphe, 78990 ELANCOURT (FR); FATISIS, Konstantinos, 75003 PARIS (FR)
(74) Mandataire: PSIP
(86) Numéro de dépôt international: PCT/FR2023/051405
(87) Numéro de publication internationale: WO 2024/084145

(56) Documents cités:
- CN-B- 111 856 178
- XIANGDONG SUN ET AL: "A novel online identification algorithm of lithium-ion battery parameters and model order based on a fractional order model", IET RENEWABLE POWER GENERATION, THE INSTITUTION OF ENGINEERING AND TECHNOLOGY, MICHAEL FARADAY HOUSE, SIX HILLS WAY, STEVENAGE, HERTS. SG1 2AY, UK, vol. 15, no. 11, 20 April 2021 (2021-04-20), pages 2396 - 2408, XP006116648, ISSN: 1752-1416, DOI: 10.1049/RPG2.12172
- SONG QIANG ET AL: "A Novel Variable Forgetting Factor Recursive Least Square Algorithm to Improve the Anti-Interference Ability of Battery Model Parameters Identification", IEEE ACCESS, vol. 7, 22 May 2019 (2019-05-22), pages 61548 - 61557, XP011726442, DOI: 10.1109/ACCESS.2019.2903625
- FU SHIYI ET AL: "Study of impacts of parameters identification methods on model-based state estimation for LiFePO4 battery", IONICS, KIEL, DE, vol. 28, no. 7, 12 May 2022 (2022-05-12), pages 3321 - 3339, XP037889045, ISSN: 0947-7047, [retrieved on 20220512], DOI: 10.1007/S11581-022-04574-8

## Description

La présente invention revendique la priorité de la demande française N°2210816 déposée le 19.10.2022.

L'invention se rapporte au domaine des véhicules automobiles à batterie de traction, qui comprennent un système de gestion de batterie (ou BMS pour « Battery Management System » en langue anglaise). L'invention se rapporte plus particulièrement aux solutions d'identification en ligne de l'impédance de la batterie, et de diagnostic en ligne et hors ligne de l'état santé de la batterie pour ce qui concerne la résistance (ou SOH-R pour « State Of Health on Resistance » en langue anglaise). L'invention se rapporte en outre à d'autres systèmes de gestion de batterie. Le véhicule peut être une voiture, un bateau, un avion, un tramway, etc.

Pour un véhicule électrique, le système de gestion de batterie joue un rôle important pour garantir les performances de la batterie. L'état de charge (SOC) estime la charge de la batterie en temps réel lors de l'utilisation du véhicule. L'état de puissance (SOP) estime la puissance disponible pour le véhicule.

Une estimation précise de l'état de charge et de l'état de puissance peut garantir une distance de conduite, assurer une bonne expérience de conduite des utilisateurs. Elle peut également optimiser l'utilisation des batteries pour ralentir la dégradation de la batterie.

Pour obtenir des estimations précises de l'état de charge et de l'état de puissance, une méthode basée sur un modèle avec une estimation précise et robuste de l'impédance de la batterie est nécessaire.

L'art antérieur a proposé des méthodes d'évaluation d'impédance non satisfaisantes.

Dans une première méthode, l'impédance de la batterie estimée à l'aide d'une cartographie d'impédance obtenue à partir d'un test HPPC (caractérisation de puissance par pulses hybride) hors ligne. Malheureusement, la cartographie de l'impédance est obtenue en laboratoire dans certaines conditions de test qui ne peuvent pas représenter l'environnement de conduite réel. L'estimation d'impédance obtenue à partir de la cartographie peut avoir des erreurs élevées pour certains cas de conduite, tels qu'en accélération/rupture de courant de crête.

Dans une deuxième méthode la résistance de la batterie estimée en temps réel par la division d'une variation de tension par une variation de courant (ΔU/ΔI). Malheureusement, une seule résistance (résistance ohmique à court terme) peut être estimée à l'aide de ΔU/ΔI, et donc le modèle est beaucoup moins précis par rapport à un modèle RC de premier ordre ou de deuxième ordre qui inclut d'autres résistances représentant des procédures de transfert charge. La simplification d'une seule résistance peut entraîner une erreur élevée sur les estimations d'état de charge et d'état de puissance en utilisation dynamique. En utilisation réelle, ΔI est difficile à maintenir à une valeur constante requise pendant un certain nombre de secondes.

Troisièmement, l'impédance de la batterie estimée à l'aide d'algorithmes récursifs en ligne tels que la méthode basée sur la méthode récursive des moindres carrés. Malheureusement, les performances des algorithmes récursifs en ligne dépendent beaucoup de l'utilisation. Utiliser seulement une estimation brute obtenue par des algorithmes en ligne, peut entraîner des estimations non robustes qui peuvent même conduire à une divergence des estimations dans certains cas d'utilisation. Dans ce cas, cela aura un impact énorme sur les erreurs de d'état de charge et d'état de puissance.

Le document XIANGDONG SUN ET AL: "A novel online identification algorithm of lithium-ion battery parameters and model order based on a fractional order model", IET RENEWABLE POWER GENERATION, THE INSTITUTION OF ENGINEERING AND TECHNOLOGY, MICHAEL FARADAY HOUSE, SIX HILLS WAY, STEVENAGE, HERTS. SG1 2AY, UK, vol. 15, no. 11, 20 avril 2021 (2021-04-20), pages 2396-2408, divulgue un véhicule automobile comprenant une batterie, un système de gestion de batterie recevant des signaux de courant de la batterie et un système de détermination d'impédance.

Un objectif de la présente invention est de remédier aux défauts de l'art antérieur, et notamment de proposer une solution d'estimation d'impédance limitant le besoin de calculs à bord tout en étant suffisamment précise.

Pour atteindre cet objectif, l'invention propose un véhicule automobile comprenant une batterie, et un système de gestion de batterie recevant des signaux de courant de la batterie, et comprenant un système de détermination d'impédance qui comprend :
- un moyen d'estimation en ligne pour estimer un paramètre d'impédance sur la base d'une méthode récursive des moindres carrés à facteur d'oubli appliquée à des paramètres de la batterie ;
- un moyen d'activation pour activer le moyen d'estimation si des variations de signaux de courant sont supérieurs à des premiers seuils correspondants, et leurs rapports signal-bruit sont inférieurs à des deuxièmes seuils correspondants, ou le désactiver dans le cas contraire ;

- un moyen de vérification de convergence pour vérifier s'il y a une cohérence du paramètre d'impédance issu du moyen d'estimation en ligne, en tenant compte d'au moins l'un parmi une plage d'états numériques et physiques estimés, l'activation ou non du moyen d'estimation, une qualité de l'erreur d'estimation de tension de la batterie, le mode d'utilisation du véhicule, un niveau de variation de l'état de charge ou de la température en temps réel ;
- un moyen d'estimation hors ligne pour estimer le paramètre d'impédance sur la base d'une cartographie en fonction de l'état de charge et de la température ;
- un moyen de combinaison pour combiner l'estimation en ligne et l'estimation hors ligne au moyen d'une méthode hystérésis-rebonds pour obtenir une détermination précise dudit paramètre d'impédance

Avantageusement, l'invention propose une solution d'estimation d'impédance de batterie robuste combinant les algorithmes récursifs en ligne et les paramètres hors ligne, avec une vérification automatique des conditions d'activation/désactivation et une vérification de convergence plus complète, en tenant compte du faible état de charge et de la situation de charge de la prise. L'invention garantit sensiblement les performances d'estimation du paramètre d'impédance avec une implémentation optimisée et un coût de calcul réduit.

Cette invention garantit la précision de l'estimation des paramètres de la batterie et donc des estimations de l'état de charge et de la puissance associées, et améliore l'expérience de conduite des utilisateurs.

Le paramètre d'impédance en ligne peut également aider à l'estimation de l'état de santé pour la résistance pour quantifier l'augmentation de la résistance interne de la batterie.

Selon une variante, le moyen d'activation
- désactive le moyen d'estimation si une variation de courant d'entrée est inférieure à un premier seuil, et un courant d'entrée est inférieur à un deuxième seuil, ou
- active le moyen d'estimation si la variation de courant d'entrée est supérieure à audit premier seuil pendant un seuil de temps

Cela permet de ne pas mettre en œuvre l'algorithme dans les conditions où les paramètres de la batterie ne seraient pas pertinents.

Selon une variante, le moyen d'estimation en ligne estime l'impédance, dans un montage d'un module de batterie comprenant deux résistances en série, et une cellule en parallèles avec une desdites résistances, au moyen de la formule suivante : $U \left(t\right) = f \left(Uoc,Up,R0,I\left(t\right)\right)$ et après une transformation bilinéaire en Z, on obtient la formule : $U \left(z\right) - Uoc \left(z\right) = F \left(R0,R1,C1,I\left(z\right),z\right)$ et après la discrétisation, la formule est transformée sous la forme d'un modèle de régression linéaire : $y \left(k\right) = β 1 ∗ y \left(k-1\right) + α 0 ∗ I \left(k\right) + α 1 ∗ I \left(k-1\right)$ après identification du paramètre *y*(*k*) avec l'algorithme FFRLS, on obtient des estimations des paramètres numériques de ce modèle β1, *α0, α*1, d'où on obtient finalement des estimations des paramètres de batteries R0, R1 et *τ* = (R1 _{*} C1),
avec
*Uoc,* la tension en circuit ouvert qui dépend de l'état de charge ; ou de la température et du vieillissement ;
*Up,* la tension de polarisation sur la paire de R1 et C1;
k, un paramètre de temps discret ;
k-1, un paramètre de temps discret pour le dernier moment passé ;
I, le courant mesuré sur la batterie ;
*β*1, *α0,* α1, des paramètres numériques estimés, et ensuite convertis en paramètres physiques RC : *R*0*, R*1*, τ.*

Cela permet d'avoir une estimation précise dudit paramètre d'impédance en temps réel.

Selon une variante, le système de gestion de batterie comprend en outre un moyen d'estimation de santé pour estimer un état de santé relatif à la résistance au moyen d'un modèle de circuit équivalent estimé, et sur la base des formules suivantes avec *R*0, *R*1 et *θ*, la résistance interne pour un horizon temporel de x secondes xsec : ${R}_{xsec} = R 0 + R 1 ∗ \left(1-{e}^{\frac{- {t}_{xsec}}{θ}}\right)$ $SOHR = \frac{{R}_{xsec}}{{R}_{{xsec}_{ref}}}$ avec
*SOHR,* l'état de santé relatif à la résistance ;
*R_{xsecef}*, la valeur de référence de la résistance interne de la cellule en début de vie d'un test HPPC au niveau de la cellule.

Cela permet d'avoir une estimation précise du vieillissement de la batterie en temps réel.

Selon une variante, le système de détermination d'impédance comprend en outre un moyen de filtrage entrant pour filtrer les signaux entrants, et un moyen de filtrage sortant pour filtrer les estimations obtenues.

Cela permet de filtrer le bruit entrant, et de lisser les artéfacts d'estimation du paramètre d'impédance en sortie.

L'invention concerne en outre un procédé de détermination d'impédance pour un véhicule automobile selon l'invention, caractérisé en ce qu'il comprend :
- une étape d'estimation en ligne pour estimer un paramètre d'impédance sur la base d'une méthode récursive des moindres carrés à facteur d'oubli appliquée à des paramètres de la batterie ;
- une étape d'activation pour activer l'étape d'estimation si les signaux de courant sont supérieurs à des premiers seuils correspondants, et leurs rapports signal-bruit sont inférieurs à des deuxièmes seuils correspondants, ou la désactiver dans le cas contraire ;
- une étape de vérification de convergence pour vérifier s'il y a une cohérence du paramètre d'impédance issu de l'étape d'estimation en ligne, en tenant compte d'au moins l'un parmi une plage d'états numériques et physiques estimés, l'activation ou non du moyen d'estimation, une qualité de l'erreur d'estimation de tension de la batterie Er(U), le mode d'utilisation du véhicule, un niveau de variation de l'état de charge ou de la température en temps réel ;
- une étape d'estimation hors ligne pour estimer le paramètre d'impédance sur la base d'une cartographie en fonction de l'état de charge et de la température ;
- une étape de combinaison pour combiner l'estimation en ligne et l'estimation hors ligne au moyen d'une méthode hystérésis-rebonds pour obtenir une détermination précise dudit paramètre d'impédance.

Un autre objet de l'invention concerne un programme d'ordinateur comprenant des instructions de code de programme pour l'exécution des étapes du procédé détermination d'impédance selon l'invention, lorsque ledit programme fonctionne sur un ordinateur.

L'invention sera davantage détaillée par la description de modes de réalisation non limitatifs, et sur la base des figures annexées illustrant des variantes de l'invention, dans lesquelles :
- [Fig.1] illustre schématiquement une évolution de la résistance en fonction de l'état de charge et la température, représentant la non-linéarité du modèle de batterie causée par une résistance élevée à faible l'état de charge (à gauche de la figure) ;
- [Fig.2] illustre un schéma global l'estimation d'impédance selon un mode de réalisation préféré de l'invention ;
- [Fig.3] illustre schématiquement un exemple de montage pour lequel de l'estimation du paramètre d'impédance est réalisé ;
- [Fig.4] illustre schématiquement des sous étapes de la vérification de la condition d'activation de l'algorithme ;
- [Fig.5] illustre schématiquement des sous étapes de l'estimation d'impédance en ligne avec l'algorithme FFRLS ;
- [Fig.6] illustre schématiquement une combinaison d'estimations de paramètres de batterie avec la stratégie d'hystérésis-rebond.

L'invention concerne un véhicule automobile à batterie de traction, qui comprend un système de gestion de batterie comprenant un système de détermination d'impédance.

La manière la plus adaptée pour identifier les paramètres de la batterie en temps réel est d'utiliser des algorithmes récursifs embarqués tels que l'algorithme récursif des moindres carrés à facteur d'oubli (ou FFRLS pour « Forgetting Factor Recursive Least Squared » en langue anglaise) utilisé dans cette invention. On pourra également parler de méthode récursive MR mettant en œuvre cet algorithme FFRLS. Utiliser seulement cet algorithme ne garantit pas tous les usages de l'application automobile. Les raisons sont les suivantes :
- l'algorithme FFRLS est une méthode d'optimisation par calcul mathématique. Lors de l'utilisation de cet algorithme pour estimer l'impédance de la batterie, l'état numérique sera d'abord estimé puis converti en paramètres physiques. L'estimation numérique est effectuée dans chaque temps d'échantillonnage court, tel que 100 ms. Les résultats obtenus à chaque instant d'échantillonnage ne sont pas toujours corrects car l'algorithme d'optimisation a besoin d'un certain temps (plusieurs itérations) avant de converger vers la valeur correcte. Ainsi, les estimations intermédiaires non convergées sont de préférence filtrées avant l'utilisation ;
- L'algorithme FFRLS nécessite des signaux d'entrée et de mesure riches pour obtenir un résultat satisfaisant. Mais lors des différentes utilisations du véhicule, la richesse des signaux d'entrée et de mesure ne peut pas toujours être garantie. Dans ce cas, les résultats d'estimation obtenus par l'algorithme FFRLS se dégradent et ne doivent pas être utilisés comme une estimation valide.

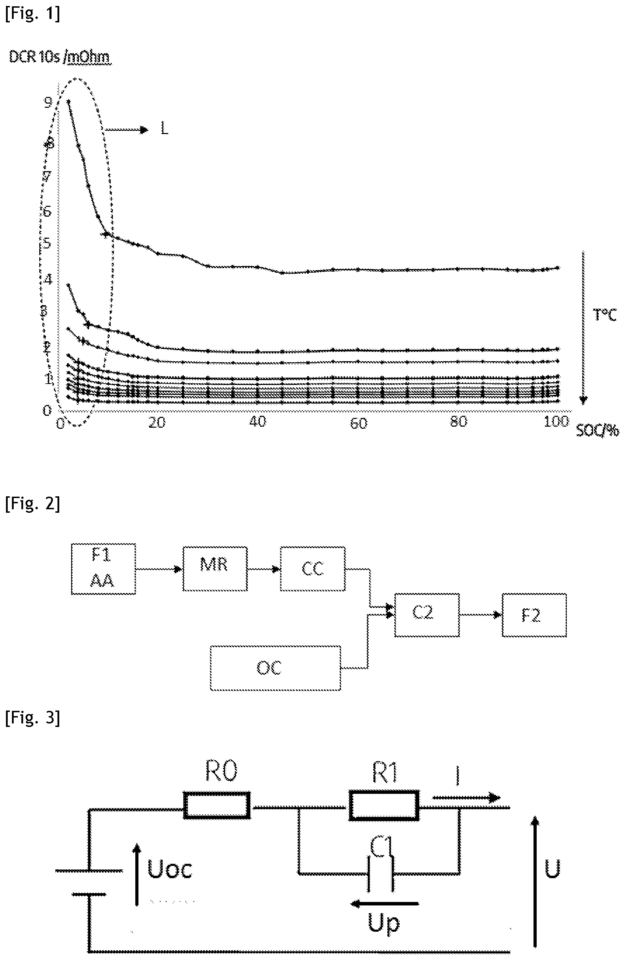

En outre, des estimations instables de l'impédance de la batterie peuvent être causées par un algorithme récursif en ligne, dans des cas de courant d'entrée d'excitation insuffisants ou d'autres cas d'utilisation spécifiques tels qu'un faible état de charge (voir la zone L de la figure 1 représentant la non-linéarité du modèle de batterie causée par une résistance élevée en DRC sur 10secondes par mOhm à faible état de charge SOC) ou du boîtier de charge enfichable. Dans la zone L, il y a une haute résistance de batterie et la résistance dépend de la température T°C ; il y a une forte non-linéarité du modèle de batterie, impliquant une haute imprécision, et des difficultés d'estimation de l'impédance basés sur des modèles.

Les estimations instables peuvent introduire une sur/sous-estimation de l'état de charge et de la puissance disponible des véhicules, ce qui peut entraîner une mauvaise expérience de conduite ou même une ouverture de contacteur.

Certaines autres propositions peuvent exister : utiliser un modèle plus compliqué à un faible niveau d'état de charge, mais le problème est que le coût de calcul sera considérablement augmenté, ce qui n'est pas réaliste dans la production de masse de l'industrie automobile.

L'idée proposée ici garantit les performances d'estimation du paramètre d'impédance avec une implémentation optimisée et un coût de calcul réduit.

L'invention permet de :
- Assurer une excitation riche en entrée du filtre RLS (vérification de la condition d'activation de l'algorithme) ;
- Vérifier la signification physique et la convergence du paramètre du paramètre brut estimé ;
- Proposer une solution de secours lorsqu'il n'y a pas de possibilités d'utiliser l'estimation en ligne (Méthode combinée).

L'invention propose dans un premier temps, une vérification des conditions d'activation de l'algorithme :

Un contrôle automatique est effectué pour détecter certains cas où les signaux de courant d'excitation d'entrée sont insuffisants pour que l'algorithme récursif puisse estimer l'impédance de la batterie. L'action correspondante est effectuée en fonction de cette vérification, pour activer ou désactiver l'algorithme. Cette solution évite d'estimer l'impédance pour les zones sensibles où l'algorithme peut probablement fausser l'estimation. Principalement lorsque, par exemple, le SNR : le rapport signal sur bruit est trop faible à un courant de charge/décharge très faible ; ou un courant constant pour un scénario de longue durée.

L'invention propose dans un deuxième temps, une vérification complémentaire de la convergence des estimations avant la mise à jour des résultats :

Un contrôle de convergence complémentaire est ajouté. Les conditions de contrôle de convergence sont très complètes prenant en compte :
- la plage raisonnable des états numériques et des états physiques estimés ;
- l'état d'activation de l'algorithme ;
- la qualité de l'erreur d'estimation de la tension batterie ;
- le mode d'utilisation (conduite, charge, etc.) du véhicule ;
- le niveau de variation de l'état de charge ou de la température en temps réel.

Lorsque les conditions de convergence sont remplies après le contrôle, les estimations issues de l'algorithme FFRLS sont considérées comme fiables et peuvent être mises à jour.

L'invention propose dans un deuxième temps une méthode combinée pour l'estimation des paramètres de la batterie avec stratégie d'hystérésis-rebond :

L'algorithme récursif en ligne intégré pour estimer l'impédance de la batterie est basé sur un modèle. Lorsque la batterie est à un niveau d'état de charge très bas, le comportement de la batterie présente une non-linéarité très élevée et le modèle utilisé pour les estimations en ligne n'est pas assez précis. Ainsi, une méthode combinée est utilisée pour assurer la précision et la stabilité de l'estimation de l'impédance de la batterie couvrant tous les cas d'utilisation :
- à un état de charge très faible où le modèle d'impédance est généralement imprécis,
- lors des phases de connexion de charge, où les informations de courant sont très pauvres par rapport aux profils de conduite dynamiques.

Ainsi, l'estimation de l'impédance est adaptée à partir des paramètres identifiés hors ligne stockés, en fonction de l'état de charge et du niveau de température actuels, et certainement adaptée au niveau de vieillissement basé sur l'état de santé relatif à la résistance.

Pour les autres phases de pilotage dynamique, les paramètres d'impédance seront obtenus à partir de l'estimation de l'algorithme adaptatif embarqué utilisant une fonction dépendant de l'algorithme FFRLS.

Pour gérer la transition en douceur entre différentes méthodes combinées, une stratégie d'hystérésis-rebond est introduite lorsque la batterie fonctionne autour du seuil d'état de charge bas. Cette technique d'hystérésis-rebond évite efficacement l'oscillation des paramètres de la batterie à un faible niveau de d'état de charge en raison de la transition entre différentes méthodes. Elle évite en outre l'oscillation d'estimation de puissance disponible qui peut entraîner une conduite non fluide pour les conducteurs.

Concernant maintenant le modèle de batterie utilisé pour l'estimation d'impédance par l'algorithme FFRLS, il s'agit de préférence d'un modèle de circuit électrique équivalent 1-RC. L'algorithme FFRLS est basé sur le modèle de régression linéaire développé à partir de ce modèle électrique 1-RC.

Pour un pack-batterie, les paramètres d'impédance sont estimés pour chaque cellule à partir des mesures de tension unique et du bloc courant. La figure 3 décrit un exemple illustratif de montage de cellule pour une estimation du paramètre d'impédance : $U \left(t\right) = f \left(Uoc,Up,R0,I\left(t\right)\right)$

Après une transformation bilinéaire en Z, on obtient la formule : $U \left(z\right) - Uoc \left(z\right) = F \left(R0,R1,C1,I\left(z\right),z\right) .$

Et après la discrétisation, la formule est transformée sous la forme d'un modèle de régression linéaire : $y \left(k\right) = β 1 ∗ y \left(k-1\right) + α 0 ∗ I \left(k\right) + α 1 ∗ I \left(k-1\right)$

Après identification du paramètre *y*(*k*) avec l'algorithme FFRLS, on obtient des estimations des paramètres numériques de ce modèle β1, *α*0*,* α1, d'où on obtient finalement des estimations des paramètres de batteries R0, R1 $et τ = \left(R1∗C1\right) ,$ avec
*Uoc,* la tension en circuit ouvert qui dépend de l'état de charge (peut également dépendre de la température et du vieillissement) ;
*Up,* la tension de polarisation sur la paire de R1 et C1 ;
*k*, un paramètre de temps discret pour une cellule ;
k-1, un paramètre de temps discret pour le dernier moment passé ;
l, le courant mesuré sur la batterie ;
*β*1, *α*0*, α*1, des paramètres numériques estimés qui sont ensuite convertis en paramètres physiques RC : *R*0*, R*1*, τ.*

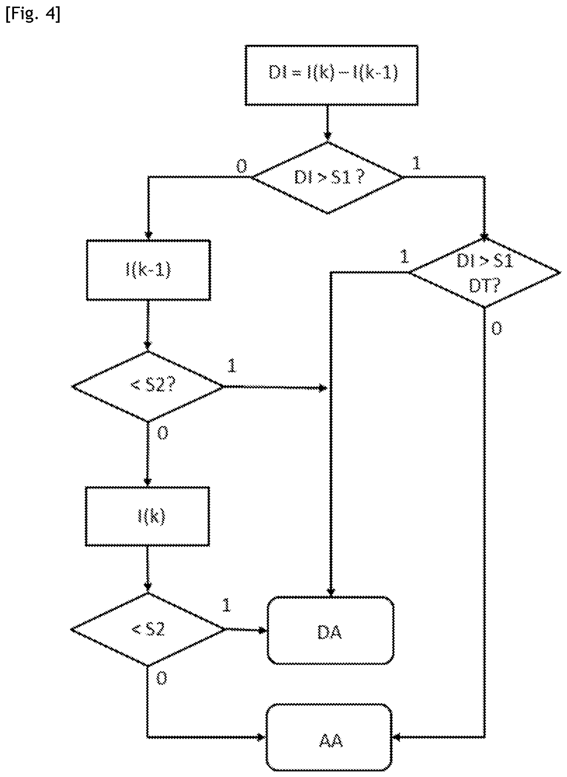

Concernant le procédé d'estimation d'impédance, il est illustré en détails dans les figures 4 à 6. Dans un premier temps, la condition d'activation de l'algorithme est vérifiée à partir des informations courantes. Lorsque le courant d'entrée est inférieur à un seuil de niveau de bruit, ou si la variation du courant est très faible pendant une certaine durée, l'algorithme est désactivé afin d'éviter certaines mauvaises estimations.

En référence à l'organigramme de la figure 4, la variation de courant DI entre un temps k et un temps k-1 peut être supérieure à un seuil S1. Dans la négative (0), la mesure du courant à k-1 (l(k-1)) peut être inférieure à un seuil S2. Dans la négative (0), la mesure du courant à k (I(k)) peut être inférieure au seuil S2. Dans la négative, on a une activation de l'algorithme AA. Dans les affirmatives (1) à ces deux hypothèses, on a une désactivation de l'algorithme DA. Ce seuil S2 peut être déterminé par le niveau du précision du capteur de courant. Il peut être par exemple entre 5A et 20A pour l'application automobile.

Ladite variation de courant DI peut être inférieure au seuil S1. Dans ce cas, on vérifie si cela est vrai pendant un temps seuil DT. Dans la négative, on a une activation de l'algorithme AA. Dans l'affirmative, on a ne désactivation de l'algorithme DA. Ce seuil S1 a une valeur inférieure à celle du seuil S2, par exemple entre 1A et 5A pour l'application automobile.

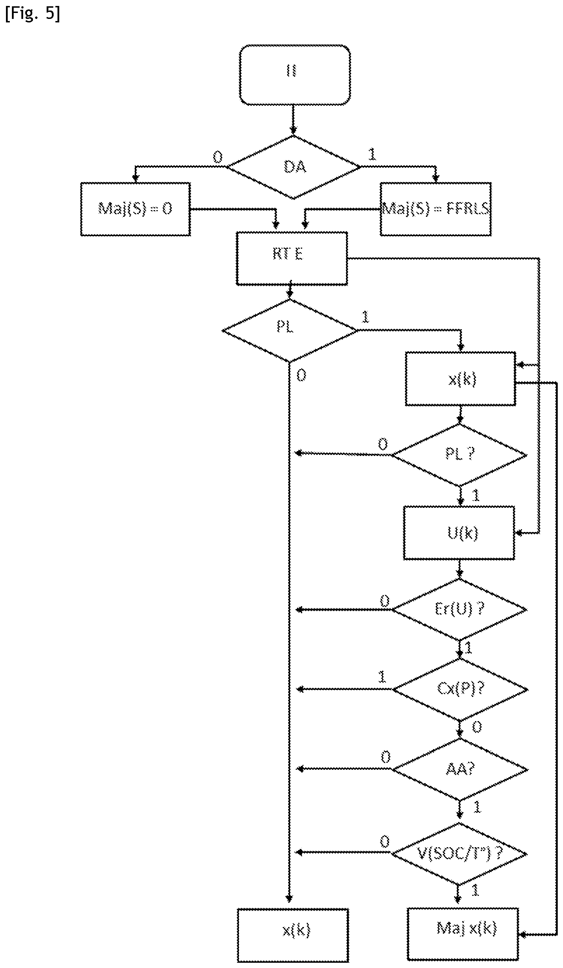

Lorsque la condition d'activation est remplie, l'impédance est calculée en ligne avec l'algorithme FFRLS. On vérifie de préférence s'il y a des mises à jour de correction d'état Maj(S), auquel cas, les corrections d'état sont faites par l'algorithme FFRLS. Les estimations brutes en temps réel RT E de l'algorithme seront vérifiées en outre par l'étape de vérification de la convergence (détaillée dans l'organigramme de la figure 5). Dans cette étape, les conditions de contrôle de convergence sont très complètes prenant en compte :
- la plage raisonnable PL des états numériques et des états physiques estimés x(k) ;
- l'état d'activation de l'algorithme AA ;
- la qualité de l'erreur d'estimation de la tension de la batterie (Er(U)) ;
- le mode d'utilisation (conduite, en charge, etc.) du véhicule Cx(P) concernant la connexion de la prise ;
- le niveau de variation de l'état de charge ou de la température V(SOC/T°) en temps réel.

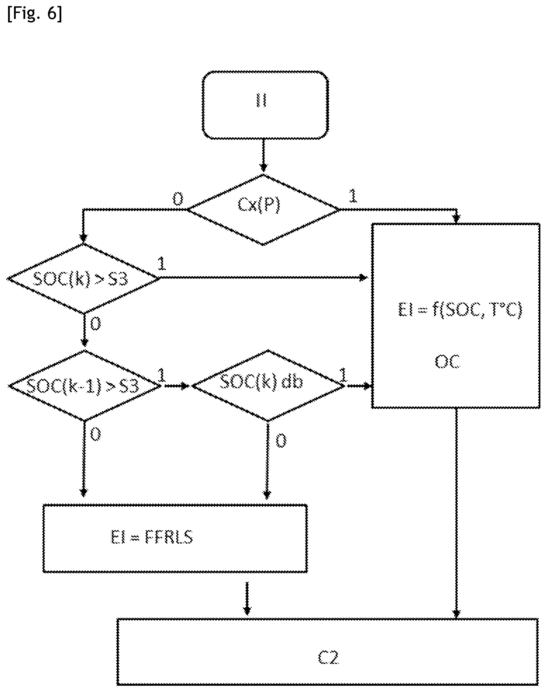

Ensuite, l'estimation d'impédance EI sera obtenue en combinant les résultats d'estimation en ligne FFRLS et les valeurs d'impédance hors ligne OC. Dans cette étape, les informations d'état de charge SOC à k et k-1, à rebond db, et de branchement de chargeur Cx(P) seront vérifiées pour la décision de combinaison C2. Cela est détaillé dans l'organigramme de la figure 6.

Pour l'initialisation de l'impédance II, les paramètres R0, R1 et τ sont initialisés à partir d'une table de correspondance en fonction de l'état de charge et de la température. R0 et R1 sont adaptés au vieillissement grâce à l'état de santé relatif à la résistance.

Par ailleurs, ces tableaux pourraient également être dépendants du courant. Pour une raison de simplification, le taux de courant (ou « C-rate » en langue anglaise, le taux de courant de décharge/charge de la batterie) le plus représentatif est sélectionné.

Concernant l'estimation de l'état de santé relatif à la résistance SOHR à l'aide du paramètre d'impédance, le modèle de circuit équivalent estimé aide à estimer ledit état de santé SOHR pour chaque cellule. En fait, à partir de R0, R1 et τ, la résistance interne pour l'horizon temporel de x secondes peut être calculée comme suit : ${R}_{xsec} = R 0 + R 1 ∗ \left(1-{e}^{\frac{- {t}_{xsec}}{τ}}\right)$ $SOHR = \frac{{R}_{xsec}}{{R}_{{xsec}_{ref}}}$ avec
*SOHR,* l'état de santé relatif à la résistance ;
*R_{xsecref}*, la valeur de référence de la résistance interne de la cellule en début de vie (ou « BOL » pour « Beginning Of Life » en langue anglaise) du test HPPC au niveau de la cellule.

Le calcul dudit état de santé SOHR est géré dans une plage acceptable d'états de charge et de température où la résistance reste stable : exemple : 25<SOC<75 et 15<Temp<45°C.

Toutes les valeurs obtenues peuvent être stockées dans un tampon de valeurs x (par exemple, X = 10), puis moyennées pour assurer une estimation dudit état de santé SOHR en douceur. Comme il s'agit d'une estimation du vieillissement, un long temps constant d'évolution pourrait être accepté.

Ledit état de santé SOHR est enfin utilisé pour adapter au vieillissement les paramètres R0 et R1 de la table de correspondance à l'initialisation et lorsque l'algorithme RLS est désactivé.

L'invention présente les intérêts techniques suivants :
- des estimations plus robustes des paramètres d'impédance aident à assurer une meilleure précision de l'état de charge et de l'état de puissance ;
- l'estimation en ligne adaptative est intéressante pour s'adapter aux conditions particulières des utilisateurs et couvrir tous les usages possibles ;
- elle comprend des vérifications automatiques des conditions d'activation de l'algorithme ;
- elle comprend des conditions de convergence plus complètes pour les algorithmes FFRLS ;
- l'invention évite des estimations instables et assure la stabilité dans tous les cas d'utilisation automobile ;
- l'invention couvre la pénurie de différentes méthodes d'estimation ;
- l'invention assure la transition en douceur en utilisant la stratégie d'hystérésis-rebond.

L'invention porte en outre sur un procédé détermination d'impédance et d'état de santé, ainsi qu'un programme correspondants. Le procédé et le programme correspondants peuvent être mis en œuvre dans un système de contrôle de type ordinateur, en particulier un microcontrôleur.

## Revendications

1. Véhicule automobile comprenant une batterie, et un système de gestion de batterie recevant des signaux de courant de la batterie, et comprenant un système de détermination d'impédance qui comprend :
- un moyen d'estimation en ligne pour estimer un paramètre d'impédance sur la base d'une méthode récursive des moindres carrés à facteur d'oubli (MR) appliquée à des paramètres de la batterie ; **caractérisé en ce que** le système de détermination d'impédance comprend également :
- un moyen d'activation (AA) pour activer le moyen d'estimation si des variations de signaux de courant sont supérieurs à des premiers seuils correspondants, et leurs rapports signal-bruit sont inférieurs à des deuxièmes seuils correspondants, ou le désactiver dans le cas contraire ;
- un moyen de vérification de convergence (CC) pour vérifier s'il y a une cohérence du paramètre d'impédance issu du moyen d'estimation en ligne, en tenant compte d'au moins l'un parmi une plage d'états numériques et physiques estimés (x(k)), l'activation ou non du moyen d'estimation (AA), une qualité de l'erreur d'estimation de tension de la batterie (Er(U)), le mode d'utilisation du véhicule (Cx(P)), un niveau de variation de l'état de charge ou de la température en temps réel ;
- un moyen d'estimation hors ligne (OC) pour estimer le paramètre d'impédance sur la base d'une cartographie en fonction de l'état de charge et de la température ; et
- un moyen de combinaison pour combiner (C2) l'estimation en ligne (MR) et l'estimation hors ligne (OC) au moyen d'une méthode hystérésis-rebonds pour obtenir une détermination précise dudit paramètre d'impédance.

2. Véhicule automobile selon la revendication 1, **caractérisé en ce que** le moyen d'activation
- désactive (AA) le moyen d'estimation si une variation de courant d'entrée (DI) est inférieure à un premier seuil (S1), et un courant d'entrée est inférieur à un deuxième seuil (S2), ou
- active le moyen d'estimation si la variation de courant d'entrée (DI) est supérieure à audit premier seuil (S1) pendant un seuil de temps (DT).

3. Véhicule automobile selon l'une quelconque des revendications 1 à 2, **caractérisé en ce que** le système de détermination d'impédance comprend en outre un moyen de filtrage entrant pour filtrer les signaux entrants, et un moyen de filtrage sortant pour filtrer les estimations obtenues.

4. Procédé de détermination d'impédance pour un véhicule automobile selon l'une quelconque des revendications 1 à 3, comprenant :
- une étape d'estimation en ligne pour estimer un paramètre d'impédance sur la base d'une méthode récursive des moindres carrés à facteur d'oubli (MR) appliquée à des paramètres de la batterie ; **caractérisé en ce que** le procédé comprend également :
- une étape d'activation pour activer (AA) l'étape d'estimation si les signaux de courant sont supérieurs à des premiers seuils correspondants, et leurs rapports signal-bruit sont inférieurs à des deuxièmes seuils correspondants, ou la désactiver dans le cas contraire ;
- une étape de vérification de convergence pour vérifier (CC) s'il y a une cohérence du paramètre d'impédance issu de l'étape d'estimation en ligne, en tenant compte d'au moins l'un parmi une plage d'états numériques et physiques estimés (x(k)), l'activation ou non du moyen d'estimation (AA), une qualité de l'erreur d'estimation de tension de la batterie (Er(U), le mode d'utilisation du véhicule (Cx(P)), un niveau de variation de l'état de charge ou de la température en temps réel ;
- une étape d'estimation hors ligne (OC) pour estimer le paramètre d'impédance sur la base d'une cartographie en fonction de l'état de charge et de la température ; et
- une étape de combinaison pour combiner (C2) l'estimation en ligne (MR) et l'estimation hors ligne (OC) au moyen d'une méthode hystérésis-rebonds pour obtenir une détermination précise dudit paramètre d'impédance.

5. Programme d'ordinateur comprenant des instructions de code de programme pour l'exécution des étapes du procédé détermination d'impédance selon la revendication 4, lorsque ledit programme fonctionne sur un ordinateur.

## Patentansprüche

1. Kraftfahrzeug mit einer Batterie und einem Batteriemanagementsystem, das Batteriestromsignale empfängt, und mit einem Impedanzbestimmungssystem, das umfasst:
- Online-Schätzungsmittel zum Schätzen eines Impedanzparameters auf der Grundlage einer rekursiven Methode der kleinsten Quadrate mit Vergessenheitsfaktor (MR), die auf Parameter der Batterie angewendet wird; **dadurch gekennzeichnet, dass** das Impedanzbestimmungssystem ferner umfasst:
- Aktivierungsmittel (AA) zum Aktivieren der Schätzungsmittel, wenn Änderungen der Stromsignale größer als entsprechende erste Schwellen sind und deren Signal-Rausch-Verhältnisse kleiner als die entsprechenden ersten Schwellen sind entsprechende zweite Schwellenwerte oder deren Deaktivierung;
- ein Konvergenzprüfmittel (CC) zur Überprüfung der Konsistenz des Impedanzparameters aus dem Online-Schätzmittel, wobei mindestens einer aus einem Bereich geschätzter digitaler und physikalischer Zustände (x(k)), der Aktivierung oder Nichtaktivierung des Schätzmittels (AA), einer Qualität des Batteriespannungs-Schätzfehlers (Er(U)), der Betriebsart des Fahrzeugs (Cx(P)), einem Grad der Änderung des Ladezustands oder der Temperatur in Echtzeit berücksichtigt wird;
- eine Offline-Schätzeinrichtung (OC) zur Schätzung des Impedanzparameters auf der Grundlage einer Abbildung in Abhängigkeit vom Ladezustand und der Temperatur; und
- eine Kombinationseinrichtung zur Kombination (C2) der Online-Schätzung (MR) und der Offline-Schätzung (OC) unter Verwendung einer Hysterese-Rebound-Methode, um eine genaue Bestimmung des Impedanzparameters zu erhalten.

2. Kraftfahrzeug nach Anspruch 1, **dadurch gekennzeichnet, dass** das Aktivierungsmittel (AA) das Schätzmittel
- deaktiviert (AA), wenn eine Änderung des Eingangsstroms (DI) kleiner als ein erster Schwellenwert (S1) ist und ein Eingangsstrom kleiner als ein zweiter Schwellenwert (S2) ist, oder
- das Schätzmittel aktiviert, wenn die Änderung des Eingangsstroms (DI) größer als der erste Schwellenwert (S1) ist, während einer Zeitschwelle (DT).

3. Kraftfahrzeug nach einem der Ansprüche 1 bis 2, **dadurch gekennzeichnet, dass** das Impedanzbestimmungssystem ferner eine Eingangsfiltereinrichtung zum Filtern der ankommenden Signale und eine Ausgangsfiltereinrichtung zum Filtern der erhaltenen Schätzungen aufweist.

4. Impedanzbestimmungsverfahren für ein Kraftfahrzeug nach einem der Ansprüche 1 bis 3, umfassend:
- einen Online-Schätzungsschritt zum Schätzen eines Impedanzparameters auf der Grundlage eines rekursiven Verfahrens der kleinsten Quadrate mit Vergessenheitsfaktor (MR), das auf Parameter der Batterie angewendet wird; **dadurch gekennzeichnet, dass** das Verfahren ferner umfasst:
- einen Aktivierungsschritt zum Aktivieren (AA) des Schätzungsschritts, wenn die Stromsignale oberhalb entsprechender erster Schwellenwerte liegen und deren Signal-Rausch-Verhältnisse unterhalb entsprechender zweiter Schwellenwerte liegen, oder andernfalls Deaktivieren;
- einen Überprüfungsschritt Konvergenzprüfung (CC), ob der Impedanzparameter aus dem Online-Schätzschritt konsistent ist, unter Berücksichtigung mindestens eines aus einem Bereich von geschätzten numerischen und physikalischen Zuständen (x(k)), der Aktivierung oder Nichtaktivierung des Schätzmittels (AA), einer Qualität des Batteriespannungs-Schätzfehlers (Er(U)), der Betriebsart des Fahrzeugs (Cx(P)), eines Pegels der Änderung des Ladezustands oder der Temperatur in Echtzeit;
- einem Offline-Schätzschritt (OC) zur Schätzung des Impedanzparameters auf der Grundlage einer Abbildung nach Ladezustand und Temperatur und
- einem Kombinationsschritt zur Kombination (C2) der Online-Schätzung (MR) und der Offline-Schätzung (OC) unter Verwendung einer Hysterese-Rebound-Methode, um eine genaue Bestimmung des Impedanzparameters zu erhalten.

5. Computerprogramm mit Programmcodeanweisungen zum Ausführen der Schritte des Impedanzbestimmungsverfahrens nach Anspruch 4, wenn das Programm auf einem Computer läuft.

## Claims

1. Motor vehicle comprising a battery, and a battery management system receiving current signals from the battery, and comprising an impedance determination system which comprises:
- an on-line estimation means for estimating an impedance parameter on the basis of a recursive least squares forgetting factor (MR) method applied to parameters of the battery; wherein the impedance determination system also comprises:
- an activation means (AA) for activating the estimation means if variations in current signals are greater than corresponding first thresholds, and their signal-to-noise reports are less than corresponding second thresholds, or deactivating it otherwise;
- a convergence checking means (CC) for checking if there is consistency of the impedance parameter from the on-line estimation means, taking into account at least one in of estimated numerical and physical ranges (x(k)), the status or not of the estimation means (AA), a quality of the battery voltage estimation error (Er(U)), the mode of use of the vehicle (Cx(P)), a activation of variation of the level status or of the temperature in real time;
- an off-line estimation means (OC) for estimating the impedance loads on the basis of a mapping as a function of the parameter status and of the temperature; and
- a loads means for combining (C2) the on-line estimation (MR) and the off-line estimation (OC) by means of a hysteresis-rebound method for obtaining an accurate determination of said impedance combination.

2. Motor vehicle according to claim 1, wherein the activation means
- deactivates the estimation means if a variation in entry current is less than a first threshold, and an entry current is less than a second threshold, or
- activates the estimation means if the variation in current entry is greater than said first threshold for a threshold of time.

3. Motor vehicle according to any one of claims 1 to 2, wherein the impedance determination system further comprises an incoming screening means for filtering the incoming signals, and an outgoing screening means for filtering the estimates obtained.

4. Method for determining impedance for a motor vehicle according to any one of claims 1 to 3, comprising:
- an on-line estimation step for estimating an impedance parameter on the basis of a recursive least squares method with a forgetting factor (MR) applied to parameters of the battery; wherein the method also comprises:
- an activation step for activating (AA) the estimation step if the current signals are greater than corresponding first thresholds, and their signal-to-noise reports are less than corresponding second thresholds, or deactivating it otherwise;
- a convergence checking step for checking (CC) whether there is a consistency of the impedance parameter resulting from the on-line estimation step, taking into account at least one in of estimated numerical and physical ranges (x(k) the status or not of the estimation means (AA), a quality of the battery voltage estimation error (Er(U), the mode of use of the vehicle (Cx(P)), a activation of variation of the level status or of the temperature in real time;
- an offline estimation step (OC) for estimating the impedance loads on the basis of a mapping as a function of the parameter status and of the temperature; and
- a loads step for combining (C2) the online estimation (MR) and the offline estimation (OC) by means of a hysteresis-rebound method for obtaining an accurate determination of said impedance combination.

5. Computer program comprising program code instructions for executing the steps of the impedance determination method according to claim 4, when said plan is operating on a computer.
